(19) **Europäisches Patentamt**
**European Patent Office**
**Office européen des brevets**

(11) **EP 2 143 134 B1**

(12) **FASCICULE DE BREVET EUROPEEN**

(45) Date de publication et mention
de la délivrance du brevet:
**29.03.2017 Bulletin 2017/13**

(51) Int Cl.:
*G11B 20/10* (2006.01)     *H01L 29/49* (2006.01)
*G11B 7/005* (2006.01)     *H01L 21/28* (2006.01)
*H01L 21/316* (2006.01)     *H01L 29/51* (2006.01)

(21) Numéro de dépôt: **08805707.0**

(22) Date de dépôt: **25.04.2008**

(86) Numéro de dépôt international:
**PCT/FR2008/050753**

(87) Numéro de publication internationale:
**WO 2008/155490 (24.12.2008 Gazette 2008/52)**

(54) **CIRCUIT ÉLECTRONIQUE INTÉGRÉ COMPRENANT UNE PORTION DE COUCHE MINCE A BASE D'OXYDE D'HAFNIUM**

INTEGRIERTER ELEKTRONISCHER SCHALTKREIS MIT EINEM DÜNNFILMTEIL AUF HAFNIUMOXIDBASIS

INTEGRATED ELECTRONIC CIRCUIT INCLUDING A THIN FILM PORTION BASED ON HAFNIUM OXIDE

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **27.04.2007 FR 0703089**

(43) Date de publication de la demande:
**13.01.2010 Bulletin 2010/02**

(73) Titulaires:
• **STMicroelectronics (Crolles 2) SAS**
  **38920 Crolles (FR)**
• **Centre National de la Recherche Scientifique (C.N.R.S.)**
  **75794 Paris Cedex 16 (FR)**
• **Institut National Polytechnique de Grenoble**
  **38031 Grenoble Cedex 1 (FR)**

(72) Inventeurs:
• **DUBOURDIEU, Catherine**
  **F-38000 Grenoble (FR)**
• **RAUWEL, Erwan Yann**
  **P-3810-157 Aveiro (PT)**
• **COSNIER, Vincent**
  **F-38000 Grenoble (FR)**
• **LHOSTIS, Sandrine**
  **F-38570 Theys (FR)**
• **BENSAHEL, Daniel-Camille**
  **F-38100 Grenoble (FR)**

(74) Mandataire: **Cabinet Plasseraud**
  **66 rue de la Chaussée d'Antin**
  **75440 Paris Cedex 09 (FR)**

(56) Documents cités:
US-A- 3 938 064     US-A1- 2004 028 952
US-A1- 2004 191 997     US-A1- 2005 040 481
US-A1- 2005 142 715

• WU KAISHENG ET AL: "Thermodynamic assessment of the HfO2-MgO system" CALPHAD. COMPUTER COUPLING OF PHASE DIAGRAMS AND THERMOCHEMISTRY, NEW YORK, NY, US, vol. 21, no. 3, 1 janvier 1997 (1997-01-01), pages 411-420, XP002459632 ISSN: 0364-5916

**Description**

La présente invention concerne un circuit électronique intégré qui comprend une portion de couche mince à base d'oxyde d'hafnium. Elle concerne aussi un procédé de formation d'une telle couche mince, ainsi que l'utilisation de ce procédé pour réaliser un circuit électronique intégré.

L'utilisation de couches minces d'oxyde d'hafnium, de formule stoechiométrique $HfO_2$, dans la fabrication de circuits électroniques intégrés est connue, notamment pour réaliser des portions de matériau à haute valeur de permittivité diélectrique. Mais cette valeur élevée de la permittivité diélectrique dépend de la structure cristallographique de l'oxyde d'hafnium. Dans sa phase monoclinique, l'oxyde d'hafnium présente une permittivité diélectrique relative $\varepsilon_r$ qui est comprise entre 16 et 20, et cette valeur devient comprise entre 25 et 80 lorsque l'oxyde d'hafnium possède une structure cubique, tétragonale ou orthorhombique.

Or, jusqu'à présent, l'oxyde d'hafnium qui est obtenu dans la fabrication de circuits électroniques intégrés est soit monoclinique, soit amorphe. Mais quand il est amorphe, il cristallise ultérieurement sous forme monoclinique lorsque que le circuit est chauffé pendant sa fabrication, après la formation de la portion d'oxyde d'hafnium. La permittivité diélectrique relative de la portion d'oxyde d'hafnium redevient alors inférieure à 20 environ.

Des portions d'oxyde d'hafnium qui contiennent en outre des atomes de scandium (Sc), d'yttrium (Y), d'aluminium (Al) ou de titane (Ti) ont aussi été réalisées au sein de circuits électroniques intégrés, pour stabiliser une phase amorphe d'un oxyde mixte d'hafnium et d'un de ces métaux. Mais, pour ces métaux ajoutés, le matériau d'oxyde mixte qui est obtenu présente encore une permittivité diélectrique insuffisante. De plus, pour certains d'entre eux, le matériau d'oxyde mixte cristallise encore en structure monoclinique.

Le document US 2004/0028952 divulgue d'utiliser un oxyde mixte d'hafnium et de magnésium pour former des couches diélectriques d'isolation de grilles de transistors, lorsque cet oxyde mixte d'hafnium et de magnésium se trouve dans une phase cristallographique qui est cubique.

Un but de la présente invention est alors de proposer un matériau à base d'oxyde d'hafnium, qui est adapté à la fabrication de circuits électroniques intégrés et qui présente une permittivité diélectrique élevée.

Un autre but de l'invention consiste à proposer un matériau à base d'oxyde d'hafnium, qui est adapté à la réalisation de portions isolantes électriquement ayant des courants de fuite très faibles.

Pour cela, l'invention propose un circuit électronique intégré qui comprend au moins une portion de couche mince à base d'oxyde d'hafnium, cette portion contenant en outre des atomes de magnésium sous forme d'un oxyde mixte d'hafnium et de magnésium. Selon l'invention, la portion d'oxyde mixte d'hafnium et de magnésium possède au moins en partie une structure cristalline tétragonale ou orthorhombique et présente une permittivité diélectrique comprise entre 30 et 50.

Au sens de l'invention, on entend par couche mince une couche de matériau qui a deux faces sensiblement parallèles séparées par une épaisseur de couche inférieure à 5 micromètres. L'obtention du matériau d'oxyde mixte sous la forme d'une telle couche mince est particulièrement adaptée à la fabrication d'un circuit électronique intégré qui présente une structure en couches superposées sur un substrat.

On entend aussi par oxyde mixte d'hafnium et de magnésium soit un composé homogène d'oxyde de ces deux métaux, soit un mélange d'un tel composé avec de l'oxyde de magnésium MgO, soit un mélange d'oxyde de magnésium MgO et d'oxyde d'hafnium $HfO_2$. De façon générale, un oxyde mixte d'hafnium et de magnésium tel que considéré dans la présente invention correspond à la formule $HfMg_xO_y$, où x et y sont des coefficients stoechiométriques qui ne sont pas nécessairement entiers.

Grâce à la présence des atomes de magnésium dans la portion, en combinaison avec l'oxyde d'hafnium, la portion de couche mince qui est obtenue présente une permittivité diélectrique relative qui est élevée. Cette permittivité est supérieure à 30 et inférieure à 50.

D'après les inventeurs, cet intervalle de valeur pour la permittivité diélectrique relative de la portion de couche mince correspondrait au fait que le matériau d'oxyde mixte est amorphe, tel que cela peut être déterminé d'après une analyse par diffraction de rayons X. Néanmoins, il possède au moins en partie une structure cristalline tétragonale ou orthorhombique, avec des grains très petits. La forme amorphe est particulièrement avantageuse pour la réalisation d'une couche d'isolation de grille d'un transistor MOS. En effet, elle évite l'apparition de phonons de résonance qui sont susceptibles de modifier la conductivité du canal du transistor. Une telle interaction néfaste entre la couche d'isolation de grille et le canal est bien connue et couramment désignée par «remote phonon scattering» en anglais.

Certains avantages de l'intervalle de valeurs 30-50 pour la permittivité diélectrique relative d'une portion de couche mince d'oxyde mixte d'hafnium et de magnésium, conforme à l'invention, apparaissent particulièrement lorsqu'on considère l'épaisseur de silice qui est équivalente électriquement à l'épaisseur réelle de cette portion. Cette épaisseur équivalente, qui est désignée par EOT pour «Electric Oxide Thickness» en anglais, est égale à :

$$EOT = \frac{\varepsilon_r(SiO_2)}{\varepsilon_r} \times e$$

où $\varepsilon_r$ et e désignent respectivement la permittivité diélectrique relative et l'épaisseur réelle de la portion de couche mince d'oxyde mixte d'hafnium et de magnésium,

et $\varepsilon_r(SiO_2)$ désigne la permittivité diélectrique relative de la silice. De façon usuelle, $\varepsilon_r(SiO_2)$ est égale à 3,9 environ.

Ainsi, pour obtenir une épaisseur équivalente EOT d'environ 1,6 nm (nanomètre) pour une couche d'isolation de grille de transistor MOS, l'épaisseur réelle e de cette couche est comprise entre 12,3 et 20,5 nm lorsqu'elle est constituée d'oxyde mixte d'hafnium et de magnésium avec une permittivité diélectrique relative $\varepsilon_r$ qui est comprise entre 30 et 50. De telles épaisseurs réelles de couche d'isolation de grille, supérieures à celles de couches d'isolation en silice équivalentes électriquement, permettent d'obtenir des courants de fuite par effet tunnel qui sont fortement réduits, à travers la couche d'isolation de grille. En outre, de telles épaisseurs réelles pour la couche d'isolation de grilles des transistors MOS ne sont pas trop importantes par rapport au design du circuit électronique intégré. En particulier, les portions de couche d'isolation de grille qui en résultent ne perturbent pas la solidité mécanique du circuit réalisé par couches superposées, et aucun effet de pointe n'apparaît qui soit susceptible de provoquer des claquages électriques dans le circuit. Pour ces raisons, l'intervalle de valeurs 30 à 50 est plus particulièrement préféré pour la permittivité diélectrique relative d'une portion d'oxyde mixte d'hafnium et de magnésium selon l'invention.

Une portion de couche mince d'oxyde mixte d'hafnium et de magnésium conforme à l'invention peut donc constituer de façon avantageuse au moins une partie d'une couche d'isolation de grille d'un transistor MOS dans un circuit électronique intégré. Les inventeurs ont en outre constaté qu'une telle portion d'oxyde mixte d'hafnium et de magnésium présente les avantages supplémentaires suivants pour cette application :

- elle ne présente aucun effet de charge irréversible, de sorte qu'aucune hystérésis n'apparaît lors d'un cycle de polarisation diélectrique de la portion ; et
- par rapport à une portion d'oxyde d'hafnium pur ($HfO_2$), l'introduction des atomes de magnésium (Mg) modifie le travail de sortie des électrons («work function» en anglais) de la portion vers des valeurs plus proches du seuil de la bande de conduction du silicium. Ce seuil de la bande de conduction du silicium est situé à environ - 4,05 eV par rapport à l'état libre d'un électron. Une portion d'oxyde mixte d'hafnium et de magnésium selon l'invention est donc particulièrement avantageuse pour la réalisation d'un transistor de type PMOS.

Selon une autre application, une portion de couche mince d'oxyde mixte d'hafnium et de magnésium conforme à l'invention peut aussi constituer une partie au moins d'un diélectrique d'un condensateur du circuit. Un tel condensateur peut être, notamment, du type MIM, pour «Métal-Isolant-Métal». Ce peut être aussi un condensateur de découplage, un condensateur de circuit analogique, un condensateur de mémoire, etc.

L'invention propose aussi un procédé de formation d'une couche mince contenant un oxyde mixte d'hafnium et de magnésium sur un substrat, cet oxyde mixte d'hafnium et de magnésium possédant au moins en partie une structure cristalline tétragonale ou orthorhombique et présentant une permittivité diélectrique comprise entre 30 et 50, ce procédé comprenant les étapes suivantes :

- chauffer le substrat à l'intérieur d'une enceinte qui contient de l'oxygène ;
- relier, par l'intermédiaire d'un injecteur, au moins un orifice d'injection ouvert sur l'intérieur de l'enceinte à une ou plusieurs sources de précurseurs volatiles d'hafnium et de magnésium, ces précurseurs étant sous forme d'un liquide dans les sources ; et
- commander une ouverture de l'injecteur de façon à ajuster une quantité des précurseurs d'hafnium et de magnésium à l'intérieur de l'enceinte.

De préférence, une première source de précurseur d'hafnium et une seconde source de précurseur de magnésium sont reliées à l'enceinte par des injecteurs respectifs qui sont distincts. Des durées d'ouverture respectives des deux injecteurs peuvent alors être ajustées pour obtenir une proportion d'atomes de magnésium dans la couche qui est comprise entre 15% et 50%, par rapport à la quantité totale d'atomes de magnésium et d'hafnium qui sont contenus dans cette couche. Cette proportion est plus précisément comprise entre 20% et 40% pour les valeurs de permittivité diélectrique les plus élevées qui ont été obtenues. En outre, les précurseurs d'hafnium et de magnésium sont de préférence des composés organométalliques qui contiennent des ligands de type alkyl ou alkoxyde. En effet, de tels précurseurs possèdent une volatilité et une réactivité qui ne nécessitent que des appareils simples et couramment disponibles pour mettre en oeuvre un procédé selon l'invention.

Un tel procédé peut être utilisé en particulier pour fabriquer un circuit électronique intégré qui incorpore au moins une portion de couche mince contenant un oxyde mixte d'hafnium et de magnésium. Une telle portion d'oxyde mixte d'hafnium et de magnésium peut notamment être obtenue avec une vitesse de dépôt qui est proche de celle d'une portion d'oxyde d'hafnium pur ($HfO_2$), et peut être gravée de la même manière que cette dernière. L'utilisation d'une portion d'oxyde mixte d'hafnium et de magnésium conforme à l'invention peut donc facilement être intégrée dans la fabrication d'un circuit électronique intégré.

D'autres particularités et avantages de la présente invention apparaîtront dans la description ci-après d'un exemple de réalisation non limitatif, en référence aux dessins annexés, dans lesquels :

- la figure 1 est une vue en coupe d'un circuit électronique intégré qui incorpore un transistor MOS, réalisé en utilisant l'invention ; et

- la figure 2 illustre un dispositif de formation d'une couche mince contenant un oxyde mixte d'hafnium et de magnésium, au sein d'un circuit électronique intégré.

L'invention est maintenant décrite en détail dans le cadre de la réalisation d'une couche mince d'isolation de grilles de transistors MOS, au sein d'un circuit électronique intégré. Il est entendu que cette application de l'invention n'est prise qu'à titre d'exemple, et que des portions d'oxyde mixte d'hafnium et de magnésium conformes à l'invention peuvent être utilisées pour d'autres applications, au sein de circuits électroniques ou dans d'autres dispositifs.

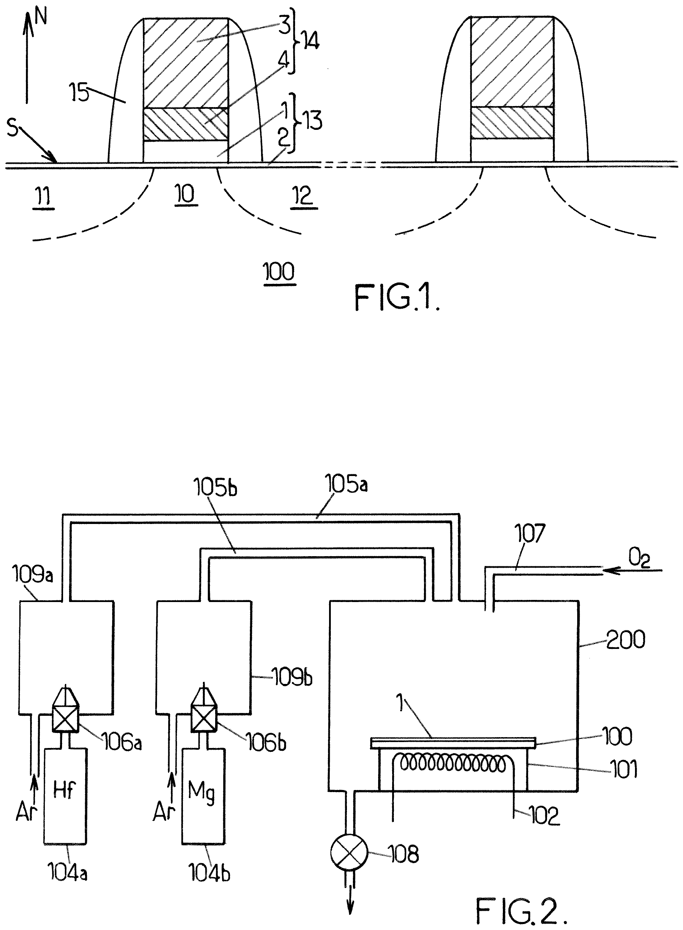

La figure 1 représente une portion d'un circuit électronique intégré qui comprend deux transistors MOS, qui sont identiques à titre d'illustration seulement. Pour raison de clarté de la figure, les dimensions des parties de composants électroniques qui sont représentées ne correspondent pas à des dimensions ou des rapports de dimensions réels. N désigne une direction qui est perpendiculaire à une surface d'un substrat du circuit, et qui est orientée vers le haut de la figure 1, le circuit étant situé dans la partie inférieure de cette figure. Les mots «sur», «sous», «inférieur» et «supérieur» qui sont utilisés dans la suite le sont en référence à cette orientation.

Conformément à cette figure, le circuit électronique intégré comprend un substrat 100, par exemple en silicium monocristallin (Si-mono), à la surface duquel sont réalisés les transistors MOS. La surface du substrat 100 est notée S. Chacun des transistors comprend une zone de source et une zone de drain, référencées 11 et 12 et disposées sur deux côtés opposés d'un canal 10 de ce transistor. Les zones 11 et 12 ainsi que le canal 10 sont réalisés en dopant de façon convenable le substrat 100, d'une façon qui est connue en soi pour des transistors MOS.

Une structure de grille est formée au dessus du canal 10, sur la surface S du substrat 100. Elle comprend une portion de couche d'isolation de grille 1, une portion de grille 14 et un espaceur 15.

Selon l'invention, la portion 1 est constituée d'un oxyde mixte d'hafnium et de magnésium $HfMg_xO_y$. De préférence, la proportion d'atomes de magnésium par rapport à la quantité totale d'atomes de magnésium et d'hafnium qui sont contenus dans la portion 1, c'est-à-dire le rapport $x/(1+x)$, est comprise entre 0,15 et 0,50. Dans ce cas, la portion 1 présente une permittivité diélectrique relative $\varepsilon_r$ qui est comprise entre 25 et 80. Lorsque ce rapport est compris plus particulièrement entre 0,20 et 0,40, $\varepsilon_r$ est compris entre 30 et 50.

Avantageusement, la portion 1 peut être séparée du canal 10 par une couche intermédiaire 2. Une telle couche intermédiaire facilite la croissance du matériau d'oxyde mixte d'hafnium et de magnésium sur la surface S du substrat 100, de façon à obtenir une interface régulière à la limite inférieure de la portion 1.

Lorsque la couche intermédiaire 2 est isolante électriquement, elle réalise avec la portion 1 l'isolation entre la grille 14 et le canal 10. Cette isolation est référencée globalement 13 sur la figure 1. Eventuellement, la couche 2 peut être continue à la surface S du substrat 100, comme représenté sur la figure 1. Les inventeurs ont constaté que la silice ($SiO_2$) est un matériau adapté pour constituer au moins en partie la couche 2, sur lequel le matériau d'oxyde mixte de la portion 1 peut être formé avec peu de défauts. Par exemple, la couche 2 peut être réalisée en effectuant une oxydation de la surface supérieure du substrat 100, dans des conditions contrôlées.

De préférence, la portion 1 d'oxyde mixte d'hafnium et de magnésium peut posséder une épaisseur qui est comprise entre 1 et 6 nm, et la couche intermédiaire 2 de silice peut posséder une épaisseur inférieure à 1.0 nm, ces épaisseurs étant mesurées selon la direction N, perpendiculairement à l'interface entre la portion 1 et la couche 2.

Lorsque la permittivité diélectrique relative de la portion 1 est égale à 40 et les épaisseurs de la portion 1 et de la couche 2 respectivement égales à 4,8 nm (nanomètre) et 0,7 nm, l'épaisseur équivalente EOT est égale à $0,7+4,8\cdot3,9/40=1,16$ nm. L'épaisseur réelle importante de la portion 1, par rapport à une épaisseur usuelle de couche d'isolation de grille en silice, assure une valeur de courant de fuite du transistor à l'état off qui est très faible. Cette valeur peut être inférieure à $10^{-7}$ A/cm$^2$ (Ampère par centimètre-carré de surface de grille parallèle à la surface S) lorsqu'une tension électrique de - 1 V (Volt) est appliquée à la portion de grille 14 par rapport au substrat 100.

De façon encore plus préférée, la portion 1 et la couche 2 possèdent des épaisseurs respectives qui sont comprises entre 2 et 3 nm pour la première, et entre 0,5 et 0,8 nm pour la seconde.

La portion de grille 14 peut elle-même comprendre une portion 3 de polysilicium (Si-poly). De préférence, elle comprend aussi une couche d'un métal ou d'un nitrure métallique 4 qui sépare la portion 3 de la portion 1 d'oxyde mixte d'hafnium et de magnésium. Grace à l'utilisation d'une portion de grille 3 qui est en polysilicium, le procédé MOS de réalisation de la structure de grille du transistor est peu modifié par rapport au procédé usuel qui est bien maîtrisé industriellement à l'heure actuelle. La couche 4 peut être, par exemple, en cobalt (Co), en cuivre (Cu), en nickel (Ni), en tungstène (W), en titane (Ti), en tantale (Ta), en iridium (Ir), ou en un alliage de ces métaux. Elle peut aussi être en germanium (Ge) ou en un nitrure métallique qui est sensiblement équivalent électriquement à une couche de métal. L'intercalation d'une telle couche 4 entre les portions 1 et 3 assure qu'une atmosphère réductrice qui est mise en contact avec le circuit intégré lors de la formation de la portion de polysilicium 3 ne provoque aucune réduction de l'oxyde mixte d'hafnium et de magnésium de la portion 1. Par exemple, la couche 4 peut posséder une épaisseur qui est comprise entre 5 et 10 nm, selon la direction N perpendiculaire à l'interface entre la couche 4 et la portion 1. Le matériau de la portion 1 ne subit alors aucune altération lors de la formation de la portion 3. En outre, une telle épaisseur de la couche 4 est suffisamment faible, lorsque la structure de grille possède une hauteur totale d'environ 100 nm selon la direction N, pour que l'étape de gravure de grille du procédé de réalisation de transistors MOS ne soit pas substantiellement modifiée, notamment dans sa durée.

L'espaceur 15 peut ensuite être formé de façon usuelle, par exemple en déposant une couche sensiblement conforme de nitrure de silicium ($Si_3N_4$) sur le circuit, puis en effectuant une gravure directionnelle de cette couche, parallèlement à la direction N et en sens opposé à celle-ci.

On décrit maintenant un procédé de formation d'une couche mince d'oxyde mixte d'hafnium et de magnésium conforme à l'invention, en référence à la figure 2. Pour la fabrication d'un circuit électronique intégré du type illustré sur la figure 1, ce procédé peut être mis en oeuvre entre la formation de la couche intermédiaire 2 et celle de la couche de métal ou de nitrure métallique 4.

Le substrat 100 est introduit dans une enceinte de dépôt étanche 200. A l'intérieur de cette enceinte, il est disposé sur un support 101 qui est équipé d'un système de chauffage 102. L'enceinte 200 est munie de deux systèmes d'introduction de précurseurs, d'une ligne d'introduction de gaz réactif 107 et d'un système d'évacuation par pompage 108. Le système de pompage 108 est ajusté par rapport à un débit total des gaz qui sont introduits dans l'enceinte 200, pour obtenir une pression totale des gaz dans l'enceinte 200 qui peut être sensiblement égale à 1,0 mbar (millibar), par exemple. Le gaz réactif peut être de l'oxygène ($O_2$), et peut être introduit dans l'enceinte 200 de façon continue. Eventuellement, ce peut être aussi de la vapeur d'eau ($H_2O$), du dioxyde de carbone ($CO_2$), de l'oxyde d'azote ($N_2O$), etc., dans une forme pure ou dans un mélange.

Le premier système d'introduction de précurseur comprend un injecteur 106a qui est connecté en sortie d'une source 104a d'un précurseur d'hafnium, et une canalisation 105a de transfert jusqu'à l'enceinte 200. De même, le second système d'introduction de précurseur comprend un injecteur 106b connecté en sortie d'une source 104b d'un précurseur de magnésium, et une canalisation de transfert 105b. Les systèmes d'introduction des précurseurs d'hafnium et de magnésium dans l'enceinte 200 sont de préférence séparés, de façon à permettre d'ajuster indépendamment les quantités respectives de ces précurseurs dans l'enceinte 200. Les injecteurs 106a et 106b ont des orifices de sortie qui débouchent à l'intérieur d'évaporateurs respectifs 109a et 109b, eux-mêmes reliés en sortie à l'enceinte 200 par les canalisations 105a et 105b. Les précurseurs d'hafnium et de magnésium des sources 104a et 104b sont choisis pour être à l'état liquide dans ces sources, jusqu'aux orifices de sortie des injecteurs 106a et 106b. Ils sont vaporisés immédiatement après leur introduction dans les évaporateurs correspondants, puis transportés jusqu'à l'enceinte 200 sous forme de vapeur dans les canalisations 105a et 105b. Pour cela, ces canalisations, ainsi que les évaporateurs 109a et 109b, peuvent être chauffées.

Un gaz porteur, qui peut être de l'argon (Ar) ou de l'azote ($N_2$), est amené en outre dans l'enceinte 200. Il est de préférence introduit dans les évaporateurs 109a et 109b, pour entraîner efficacement les vapeurs des précurseurs d'hafnium et de magnésium.

Les injecteurs 106a et 106b peuvent être d'un modèle à ouvertures intermittentes, par exemple à une fréquence qui est comprise entre 0,1 et 10 Hz (Hertz), et avec un rapport de la durée d'ouverture par rapport à la durée d'un cycle d'injection qui est compris entre 1/50 et 1/2. Les durées d'ouvertures respectives des deux injecteurs 106a et 106b peuvent être ajustées pour obtenir des pressions partielles des précurseurs d'hafnium et de magnésium dans l'enceinte 200 qui sont respectivement sensiblement égales à $5,2.10^{-6}$ mbar et à $3,4.10^{-6}$ mbar, par exemple.

Le précurseur d'hafnium peut être le tétratertiobutoxyde d'hafnium (Hf ($O^tBu)_4$) ou le ditertiobutoxy-diméthoxyméthylpropoxyde d'hafnium (Hf($O^tBu)_2(mmp)_2$). Le précurseur de magnésium peut être le ditétraméthylheptanedionate de magnésium (Mg(tmhd)$_2$).

Le procédé utilisé est du type dépôt chimique en phase vapeur à partir de précurseurs organométalliques et à injection liquide pulsée. La température du substrat 100 pendant le dépôt est comprise entre 400°C et 600°C, et les concentrations des précurseurs présents sous forme gazeuse à l'intérieur de l'enceinte 200 sont ajustées pour obtenir une vitesse de formation de la couche 1 d'oxyde mixte d'hafnium et de magnésium qui est de l'ordre de 0,6 nm par minute. Dans ces conditions, la couche 1 d'oxyde mixte présente une concentration résiduelle de carbone qui est très faible. La couche 1 qui est obtenue correspond alors à la formule stoechiométrique $HfMg_xO_y$, ou à un mélange d'un composé associé à cette formule avec de l'oxyde de magnésium MgO.

Lors de la fabrication d'un circuit électronique intégré tel qu'illustré sur la figure 1, la couche continue 1 d'oxyde mixte d'hafnium et de magnésium qui est obtenue par un procédé tel que décrit précédemment est gravée après l'étape couramment désignée par gravure de grille. Cette gravure de la couche 1, de type gravure directionnelle, est couramment effectuée au moyen d'un plasma dont des particules sont accélérées en direction de la surface du circuit, parallèlement à la direction N.

Il est entendu que de nombreuses modifications peuvent être introduites dans le procédé de formation d'une couche d'oxyde mixte d'hafnium et de magnésium qui vient d'être décrit. En particulier, une source unique de précurseurs des deux métaux peut être utilisée, qui contient un mélange des précurseurs respectifs de ceux-ci. Les proportions du mélange sont alors adaptées pour obtenir une stoechiométrie voulue de l'oxyde mixte. Enfin, les valeurs numériques des paramètres de dépôt qui ont été citées ne l'ont été qu'à but illustratif, et peuvent être modifiées tout en obtenant encore une couche d'oxyde mixte conforme à l'invention.

**Revendications**

1. Circuit électronique intégré comprenant au moins une portion de couche mince à base d'oxyde d'hafnium (1), ladite portion contenant en outre des atomes de magnésium sous forme d'un oxyde mixte d'hafnium et de magnésium, **caractérisé en ce que** la portion d'oxyde mixte d'hafnium et de magnésium (1) possède au moins en partie une structure cristalline tétragonale ou orthorhombique et présente une permittivité diélectrique comprise entre 30 et 50.

2. Circuit selon la revendication 1, dans lequel la proportion d'atomes de magnésium par rapport à une quantité totale d'atomes de magnésium et d'hafnium contenus dans la portion d'oxyde mixte est comprise entre 0,20 et 0,40.

3. Circuit selon la revendication 1 ou 2, dans lequel la portion d'oxyde mixte d'hafnium et de magnésium constitue une partie au moins d'un diélectrique d'un condensateur dudit circuit.

4. Circuit selon la revendication 1 ou 2, dans lequel la portion d'oxyde mixte d'hafnium et de magnésium (1) constitue une partie au moins d'une couche d'isolation de grille (13) d'un transistor MOS dudit circuit.

5. Circuit selon la revendication 4, dans lequel la portion d'oxyde mixte d'hafnium et de magnésium (1) est séparée d'un canal du transistor (10) par une couche intermédiaire (2).

6. Circuit selon la revendication 5, dans lequel la couche intermédiaire (2) est au moins en partie à base de silice.

7. Circuit selon la revendication 5 ou 6, dans lequel la portion d'oxyde mixte d'hafnium et de magnésium (1) possède une épaisseur comprise entre 1 et 6 nm, et la couche intermédiaire (2) possède une épaisseur inférieure à 1.0 nm, lesdites épaisseurs étant mesurées selon une direction (N) perpendiculaire à une interface entre la portion d'oxyde mixte d'hafnium et de magnésium et la couche intermédiaire.

8. Circuit selon la revendication 7, dans lequel la portion d'oxyde mixte d'hafnium et de magnésium (1) possède une épaisseur comprise entre 2 et 3 nm, et la couche intermédiaire (2) possède une épaisseur comprise entre 0,5 et 0,8 nm.

9. Circuit selon l'une quelconque des revendications 4 à 8, dans lequel la grille du transistor (14) comprend une portion de polysilicium (3).

10. Circuit selon la revendication 9, dans lequel la portion de polysilicium de la grille (3) est séparée de la portion d'oxyde mixte d'hafnium et de magnésium de la couche d'isolation de grille (1) par une couche d'un métal ou d'un nitrure métallique (4).

11. Circuit selon la revendication 10, dans lequel la couche de métal ou de nitrure métallique (4) possède une épaisseur comprise entre 5 et 10 nm, selon une direction (N) perpendiculaire à une interface entre ladite couche de métal ou de nitrure métallique et la portion de polysilicium.

12. Procédé de formation d'une couche mince (1) contenant un oxyde mixte d'hafnium et de magnésium sur un substrat (100), ledit oxyde mixte d'hafnium et de magnésium possédant au moins en partie une structure cristalline tétragonale ou orthorhombique et présentant une permittivité diélectrique comprise entre 30 et 50, ledit procédé comprenant les étapes suivantes :

   - chauffer le substrat (100) à l'intérieur d'une enceinte (200) contenant de l'oxygène, à une température comprise entre 400°C et 600°C ;
   - relier, par l'intermédiaire d'un injecteur (106a, 106b), au moins un orifice d'injection ouvert sur l'intérieur de l'enceinte (200) à une ou plusieurs sources de précurseurs volatiles d'hafnium et de magnésium (104a, 104b), lesdits précurseurs étant sous forme d'un liquide dans lesdites sources ; et
   - commander une ouverture de l'injecteur (106a, 106b) de façon à ajuster une quantité des précurseurs d'hafnium et de magnésium à l'intérieur de l'enceinte (200).

13. Procédé selon la revendication 12, suivant lequel une première source de précurseur d'hafnium (104a) et une seconde source de précurseur de magnésium (104b) sont reliées à l'enceinte (200) par des injecteurs respectifs distincts (106a, 106b), et suivant lequel des durées d'ouverture respectives desdits injecteurs sont ajustées pour obtenir une proportion d'atomes de magnésium dans la couche (1) comprise entre 0,20 et 0,40, par rapport à une quantité totale d'atomes de magnésium et d'hafnium contenus dans ladite couche.

14. Procédé selon la revendication 12 ou 13, suivant lequel les précurseurs d'hafnium et de magnésium sont des composés organométalliques contenant des ligands de type alkyl ou alkoxyde.

15. Utilisation d'un procédé selon l'une quelconque des revendications 12 à 14 pour fabriquer un circuit électronique intégré qui incorpore au moins une portion de couche mince contenant un oxyde mixte d'hafnium et de magnésium.

**Patentansprüche**

1. Integrierter elektronischer Schaltkreis, der mindestens einen Dünnfilmteil auf Hafniumoxidbasis (1) umfasst, wobei der Teil außerdem Magnesiumatome in Form eines Hafnium- und Magnesium-Mischoxids enthält,
**dadurch gekennzeichnet, dass** der Hafnium- und Magnesium-Mischoxidteil (1) mindestens zum Teil eine tetragonale oder orthorhombische kristalline Struktur besitzt und eine Dielektrizitätskonstante zwischen 30 und 50 aufweist.

2. Schaltkreis nach Anspruch 1, wobei der Anteil von Magnesiumatomen im Vergleich zu der Gesamtmenge von Magnesium- und Hafniumatomen, die in dem Mischoxidteil enthalten sind, zwischen 0,20 und 0,40 liegt.

3. Schaltkreis nach Anspruch 1 oder 2, wobei der Hafnium- und Magnesium-Mischoxidteil mindestens einen Teil eines Dielektrikums eines Kondensators des Schaltkreises bildet.

4. Schaltkreis nach Anspruch 1 oder 2, wobei der Hafnium- und Magnesium-Mischoxidteil (1) mindestens einen Teil einer Gitterisolierschicht (13) eines MOS-Transistors des Schaltkreises bildet.

5. Schaltkreis nach Anspruch 4, wobei der Hafnium- und Magnesium-Mischoxidteil (1) von einem Kanal des Transistors (10) durch eine Zwischenschicht (2) getrennt ist.

6. Schaltkreis nach Anspruch 5, wobei die Zwischenschicht (2) mindestens zum Teil auf Siliziumdioxid basiert.

7. Schaltkreis nach Anspruch 5 oder 6, wobei der Hafnium- und Magnesium-Mischoxidteil (1) eine Stärke zwischen 1 und 6 nm besitzt, und die Zwischenschicht (2) eine Stärke kleiner als 1,0 nm besitzt, wobei die Stärken gemäß einer Richtung (N) senkrecht zu einer Grenzfläche zwischen dem Hafnium- und Magnesium-Mischoxidteil und der Zwischenschicht gemessen werden.

8. Schaltkreis nach Anspruch 7, wobei der Hafnium- und Magnesium-Mischoxidteil (1) eine Stärke zwischen 2 und 3 nm besitzt, und die Zwischenschicht (2) eine Stärke zwischen 0,5 und 0,8 nm besitzt.

9. Schaltkreis nach einem der Ansprüche 4 bis 8, wobei das Gitter des Transistors (14) einen Polysiliziumabschnitt (3) umfasst.

10. Schaltkreis nach Anspruch 9, wobei der Polysiliziumabschnitt des Gitters (3) von dem Hafnium- und Magnesium-Mischoxidteil der Gitterisolierschicht (1) durch eine Schicht aus einem Metall oder einem Metallnitrid (4) getrennt ist.

11. Schaltkreis nach Anspruch 10, wobei die Metall- oder Metallnitridschicht (4) eine Stärke zwischen 5 und 10 nm entlang einer Richtung (N) senkrecht zu einer Grenzfläche zwischen der Metall- oder Metallnitridschicht und dem Polysiliziumabschnitt besitzt.

12. Verfahren zum Bilden einer Dünnfilmschicht (1), die ein Hafnium- und Magnesium-Mischoxid auf einem Substrat (100) enthält, wobei das Hafnium- und Magnesium-Mischoxid mindestens zum Teil eine tetragonale oder orthorhombische kristalline Struktur besitzt und eine Dielektrizitätskonstante zwischen 30 und 50 aufweist, wobei das Verfahren die folgenden Schritte umfasst:

    - Erhitzen des Substrats (100) im Inneren eines Gehäuses (200), das Sauerstoff enthält, auf eine Temperatur zwischen 400 °C und 600 °C,
    - Verbinden über eine Einspritzdüse (106a, 106b) mindestens einer Einspritzöffnung, die auf das Innere des Gehäuses (200) offen ist mit einer oder mehreren Quellen flüchtiger Hafnium- und Magnesium-Mutterkerne (104a, 104b), wobei die Mutterkerne die Form einer Flüssigkeit in den Quellen haben, und
    - Befehlen eines Öffnens der Einspritzdüse (106a, 106b) derart, dass eine Menge der Hafnium- und Magnesium-Mutterkerne im Inneren des Gehäuse (200) eingestellt wird.

13. Verfahren nach Anspruch 12, gemäß dem eine erste Quelle von Hafnium-Mutterkernen (104a) und eine zweite Quelle von Magnesium-Mutterkernen (104b) mit dem Gehäuse (200) durch jeweilige separate Einspritzdüsen (106a, 106b) verbunden sind, und gemäß der jeweiligen Öffnungsdauer der Einspritzdüsen eingestellt sind, um einen Anteil von Magnesiumatomen in der Schicht (1) zwischen 0,20 und 0,40 im Vergleich zu einer Gesamtmenge an Magnesium- und Hafniumatomen, die in der Schicht enthalten sind, zu erhalten.

14. Verfahren nach Anspruch 12 oder 13, gemäß dem die Hafnium- und Magnesium-Mutterkerne metallorganische Verbindungen sind, die Liganden des Typs Alkyl oder Alkoxid enthalten.

15. Einsatz eines Verfahrens nach einem der Ansprüche 12 bis 14 zum Herstellen eines integrierten elektronischen Schaltkreises, der mindestens einen Dünnfilmteil umfasst, der ein Hafnium- und Magnesium-Mischoxid enthält.

**Claims**

1. Integrated electronic circuit comprising at least one thin film portion based on hafnium oxide (1), said portion further containing magnesium atoms in a form of a mixed oxide of hafnium and magnesium, **characterized in that** the portion of mixed oxide of hafnium and magnesium (1) has at least partially a tetragonal or orthorhombic crystalline structure and has a dielectric permittivity comprised between 30 and 50.

2. Circuit according to claim 1, in which the proportion of magnesium atoms with respect to a total quantity of magnesium and hafnium atoms contained in the mixed oxide portion is comprised between 0.20 and 0.40.

3. Circuit according to claim 1 or 2, in which the portion of mixed oxide of hafnium and magnesium constitutes a part at least of a capacitor dielectric of said circuit.

4. Circuit according to claim 1 or 2, in which the portion (1) of mixed oxide of hafnium and magnesium constitutes a part at least of a gate insulating film (13) of an MOS transistor of said circuit.

5. Circuit according to claim 4, in which the portion (1) of mixed oxide of hafnium and magnesium is separated from a channel of the transistor (10) by an intermediate layer (2).

6. Circuit according to claim 5, in which the intermediate layer (2) is at least partially based on silica.

7. Circuit according to claim 5 or 6, in which the portion (1) of mixed oxide of hafnium and magnesium has a thickness comprised between 1 and 6 nm, and the intermediate layer (2) has a thickness of less than 1.0 nm, said thicknesses being measured along a direction (N) perpendicular to an interface between the portion of mixed oxide of hafnium and magnesium and the intermediate layer.

8. Circuit according to claim 7, in which the portion (1) of mixed oxide of hafnium and magnesium has a thickness comprised between 2 and 3 nm, and the intermediate layer (2) has a thickness comprised between 0.5 and 0.8 nm.

9. Circuit according to any one of claims 4 to 8, in which the transistor gate (14) comprises a polysilicon portion (3).

10. Circuit according to claim 9, in which the polysilicon portion of the gate (3) is separated from the portion of mixed oxide of hafnium and magnesium of the gate insulating film (1) by a metal or metallic nitride layer (4).

11. Circuit according to claim 10, in which the metal or metallic nitride layer (4) has a thickness comprised between 5 and 10 nm, along a direction (N) perpendicular to an interface between said metal or metallic nitride film and the polysilicon portion.

12. Method for forming a thin film (1) containing a mixed oxide of hafnium and magnesium on a substrate (100), said mixed oxide of hafnium and magnesium has at least partially a tetragonal or orthorhombic crystalline structure and having a dielectric permittivity comprised between 30 and 50, said method comprising the following steps;

    - heating the substrate (100) inside an enclosure (200) containing oxygen to a temperature of between 400°C and 600°C;
    - connecting, via an injector (106a, 106b), at least one injection aperture opening on the inside of the enclosure (200) to one or more sources of hafnium and magnesium volatile precursors (104a, 104b), said precursors being in liquid form in said sources; and
    - controlling an opening of the injector (106a, 106b) so as to adjust a quantity of the hafnium and magnesium precursors inside the enclosure (200).

13. Method according to claim 12, according to which a first source of hafnium precursor (104a) and a second source of magnesium precursor (104b) are connected to the enclosure (200) by respective separate injectors (106a, 106b), and according to which respective durations of opening of said injectors are adjusted in order to obtain a proportion of magnesium atoms in the film (1) comprised between 0.20 and 0.40, with respect to a total quantity of magnesium and hafnium contained in said film.

14. Method according to claim 12 or 13, according to which the hafnium and magnesium precursors are organometallic compounds containing ligands of alkyl or alkoxide type.

15. Use of a method according to any one of claims 12 to 14 in order to produce an integrated electronic circuit incorporating at least one thin film portion containing a mixed oxide of hafnium and magnesium.

FIG.1.

FIG.2.

**EP 2 143 134 B1**

## RÉFÉRENCES CITÉES DANS LA DESCRIPTION

**Documents brevets cités dans la description**

- US 20040028952 A